# EUROPÄISCHE PATENTANMELDUNG

(11) **EP 1 686 382 A2**
(43) Veröffentlichungstag der Anmeldung: **02.08.2006**
(21) Anmeldenummer: 06001020.4
(22) Anmeldetag: 23.09.1999
(51) Int. Cl.: G01R 1/067, G01R 1/073

(54) **Prüfsonde-Antriebsvorrichtung**

(30) Priorität: 28.09.1998 DE 19844428
(62) Teilanmeldung aus: 99118797.2
(71) Anmelder: atg test systems GmbH & Co. KG, 97877 Wertheim (DE)
(72) Erfinder: Prokopp, Manfred, 97877 Wertheim-Reicholzheim (DE); Stoehr, Roland, 71154 Nufringen (DE)
(74) Vertreter: Ganahl, Bernhard

(57) **Zusammenfassung**

Die Erfindung betrifft eine Prüfsonde für einen Fingertester mit einem Sondenelement zum elektrischen Kontaktieren einer Kontaktstelle einer zu prüfenden Leiterplatte,
einem ein Spulenelement und einen permanent vormagnetisierten Kern aufweisenden Aktuator, wobei das Spulenelement auf dem permanent vormagnetisierten Kern verschieblich angeordnet und mit dem Sondenelement mechanisch verbunden ist, so daß bei Stromschaltung des Spulenelementes das Spulenelement zusammen mit dem Sondenelement bewegt wird.

Da erfindungsgemäß der bewegliche Teil nicht mechanisch mit dem fixierten Teil verbunden ist, kann die Prüfsonde sehr schnell das Sondenelement mit einer Kontaktstelle einer zu prüfenden Leiterplatte in Kontakt bringen.

## Beschreibung

Die Erfindung betrifft eine Prüfsonde für einen Fingertester.

Prüfvorrichtungen zum Testen von Leiterplatten können grundsätzlich in zwei Gruppen eingeteilt werden, nämlich den Fingertestern und den Paralleltestern. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequentiell abtasten.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Zum Kontaktieren einer Kontaktstelle der zu prüfenden Leiterplatte ist der Schlitten an der Traverse vertikal verschieblich, so daß der Prüffinger von oben bzw. unten auf die Kontaktstelle der Leiterplatte gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben.

Aus der US 5,113,133 ist eine Prüfsonde bekannt, bei der eine als Sondenelement dienende Blattfeder in einem Kanal geführt ist. Das Sondenelement kann zum Kontaktieren der Oberfläche eines Prüflings in diesem Kanal nach unten verschoben werden, wobei sie mit einer Spitze aus dem Kanal ausfährt und eine Kontaktstelle des Prüflings kontaktiert. Mit dem zur Spitze der Blattfeder gegenüberliegendem Ende der Kontaktfeder ist diese an einer drehbaren Scheibe befestigt, wobei bei einer Drehung der Scheibe sich die Blattfeder von dieser ab- bzw. auf diese aufwickelt. Somit kann durch Drehen der Scheibe die Blattfeder im Kanal vertikal auf und ab bewegt werden.

Der Kanal ist mit einer Ausnehmung versehen, in welcher die Blattfeder ausbiegen kann, so daß die bei der "Landung" auf der Oberfläche des Prüflings auftretende Reaktionskraft absorbiert wird.

Mit dieser Sonde soll ein schneller Kontakt zwischen dem Sondenelement und einer Kontaktstelle des Prüflings erzielt werden, wobei gleichzeitig das Auftreffen des Sondenelementes auf der Oberfläche des Prüflings zu keinen Beschädigungen desselben führen soll.

Die US 5,804,982 beschreibt eine Prüfsonde für ein Testgerät zum Testen von Mikrochips. Die Prüfsonde weist einen Aktuator auf, der eine Sondenspitze vertikal verstellen kann. Der Aktuator besteht aus zwei Spulen, die horizontal liegend angeordnet sind, und zwei seitlich davon angeordneten Magneten. Dieser Aktuator bewegt zwei elastische Hebelarme, die an einem Ende ortsfest angeordnet sind und an deren anderen Enden ein Halterelement befestigt ist, an dem wiederum das Kontaktelement angeordnet ist. Bei dieser bekannten Prüfsonde wird die Sondenspitze zusammen mit dem Halterelement entgegen der Federwirkung der elastischen Hebelarme bewegt.

Das wesentliche Kriterium um Fingertester am Markt erfolgreich durchsetzen zu können, ist die Geschwindigkeit, mit der die Kontaktstellen des Prüflings kontaktiert werden können. Herkömmliche Fingertester benötigen für eine Vertikalbewegung des Prüffingers ca. 120 ms. Die aus der US 5,113,133 bekannte Prüfsonde ist schneller und benötigt nur noch einige 10 ms für eine Vertikalbewegung.

Der Erfindung liegt die Aufgabe zugrunde, eine Prüfsonde für einen Fingertester zu schaffen, die einfach aufgebaut ist und sehr schnell ein Sondenelement zur Kontaktierung einer Kontaktstelle eines Prüflings bewegen kann.

Die Aufgabe wird durch eine Prüfsonde für einen Fingertester mit den Merkmalen des Anspruchs 1 gelöst. Vorteilhafte Ausgestaltungen sind in den Unteransprüchen angegeben.

Erfindungsgemäß weist die Prüfsonde einen Aktuator mit einem permanent vormagnetisierten Kern und einem Spulenelement auf, die relativ zueinander beweglich sind, wobei eines der beiden Teile fixiert und das andere beweglich ist, und das bewegliche Teil mechanisch mit einem Sondenelement verbunden ist, so daß bei Stromschaltung das bewegliche Teil zusammen mit dem Sondenelement bewegt wird.

Die Erfindung zeichnet sich dadurch aus, daß das bewegliche Teil frei beweglich an dem fixierten Teil angeordnet ist, d.h., daß es keine mechanische Verbindung zwischen dem beweglichen Teil und dem fixierten Teil gibt. Lediglich ein elektrischer Leiter zum elektrischen Anschließen des Sondenelementes an eine Prüfvorrichtung ist zwischen dem fixierten und dem beweglichen Teil vorgesehen, der jedoch so ausgebildet ist, daß er keinen oder nur geringste, zu vernachlässigende Kräfte zwischen dem beweglichen und fixiertem Teil übertragen kann. Hierdurch kann das bewegliche Teil ohne Überwindung eines mechanischen Widerstandes schnell bewegt werden.

Nach einer bevorzugten Ausführungsform der Erfindung ist der permanent vormagnetisierte Kern fixiert und das Spulenelement bildet das bewegliche Teil, das mechanisch mit dem Sondenelement verbunden ist. Da erfindungsgemäß das Spulenelement und nicht der Kern bewegt wird, kann die Masse der beweglichen Teile und damit die Trägheit des Aktuators gering gehalten werden. Hierdurch kann eine außergewöhnlich schnelle Bewegung der Sonde erzielt werden.

Zudem nimmt das Spulenelement bei einer Ansteuerung des Aktuators, wie sie in Anspruch 11 angegeben ist, jeweils eine Null-Stellung und eine Kontaktstellung durch Stromschaltung mit einer vorbestimmten Polarität ein. Das Umschalten der Polarität geht schlagartig vonstatten, weshalb auch das Spulenelement entsprechend schlagartig angesteuert werden kann. Zudem ist zum Halten des Spulenelementes in der Null-Stellung kein Federelement oder dgl. notwendig, wie es bei herkömmlichen elektromagnetischen Aktuatoren vorgesehen wird. Solche Federelemente erhöhen die Trägheit des Aktuators, weshalb das Halten der Null-Stellung mittels eines Haltestroms eine Verbesserung des Ansprechverhaltens bewirkt.

Eine besonders vorteilhafte Ausführungsform der Prüfsonde ist in Anspruch 12 angegeben, bei der das Sondenelement ein elastischer Draht ist, der in einem Führungskanal geführt ist, der mit mehreren Ausnehmungen versehen ist, in welche der Draht bei Belastung ausbiegen kann. Es hat sich gezeigt, daß bei einer solchen Prüfsonde die vom Draht auf eine Kontaktstelle ausgeübt Kraft zunächst etwa proportional mit dem Betätigungsweg ansteigt und ab einem vorbestimmten Betätigungsweg kaum mehr zunimmt. Dieser Effekt begrenzt die maximal auf eine zu prüfende Leiterplatte auszuübende Kraft.

### Dieser Effekt ergibt sich aus folgendem:

Zum Ausbiegen des Drahtes in eine erste Ausnehmung ist eine vorbestimmte Kraft notwendig, die proportional zum Betätigungsweg, um welchen der Draht vom Aktuator verschoben wird, ist und durch die Steifigkeit des Drahtes und der Geometrie der Ausnehmung festgelegt wird. Ist der Draht in eine erste Ausnehmung ausgebogen, so wird er bei einer weiteren Betätigung des Aktuators in eine zweite oder dritte Ausnehmung ausgebogen, wobei die hier vom Aktuator aufzubringende Kraft bzw. die von der Kontaktstelle aufzubringende Gegenkraft der zum Ausbiegen in die erste Ausnehmung notwendigen Kraft entspricht. Der weitere, sehr geringfügige Anstieg der Kräfte wird durch die zusätzliche Reibung zwischen dem Draht und dem Führungskanal verursacht. Durch diese Ausbildung der Prüfsonde ist die maximal durch das Sondenelement auf die Kontaktstelle einer Leiterplatte ausgeübte Kraft auf einen vorbestimmten Wert begrenzt. Diese Begrenzung der Kraft erfolgt konstruktiv, weshalb bei der Ansteuerung des Sondenelementes zum Kontaktieren der Kontaktstelle keine Begrenzung der Zustellgeschwindigkeit notwendig ist, wie es von herkömmlichen Fingertestern bekannt ist.

Dieses Prinzip der konstruktiven Begrenzung der durch das Sondenelement auf die zu prüfende Leiterplatte ausgeübten Kraft stellt einen selbständigen Erfindungsgedanken dar.

Ein weiteres vorteilhaftes Prinzip der vorliegenden Erfindung ist in Anspruch 20 angegeben, gemäß dem ein Fingertester eine Einrichtung zum Verstellen der vertikalen Position der Prüfsonde aufweist und die Prüfsonde mit einem Aktuator versehen ist, der ein Sondenelement unabhängig von der Einrichtung zum Verstellen der vertikalen Position der Prüfsonde in Vertikalrichtung zum Kontaktieren einer Kontaktstelle einer Leiterplatte betätigen kann.

Durch die Einrichtung zum Verstellen der vertikalen Position der Prüfsonde wird eine Grobjustierung der Prüfsonde bzgl. einer zu prüfenden Leiterplatte vorgenommen, wobei der Abstand zwischen der Leiterplatte und der Prüfsonde vorzugsweise auf einen kleinen Wert, wie z.B. kleiner als 2 mm bzw. kleiner als 1 mm eingestellt wird. Hierdurch muß der Aktuator lediglich um diesen kurzen Abstand zwischen der Leiterplatte und der Prüfsonde das Sondenelement verschieben, was wesentlich einfacher und schneller ausgeführt werden kann, als wenn die üblichen Abstände zwischen einer Ausgangsposition eines Testfingers und einer zu prüfenden Leiterplatte von einigen Millimetern überwunden werden müssen.

Wegen der sehr schnellen Kontaktierung einer Kontaktstelle ist die erfindungsgemäße Prüfsonde besonders zum Testen von unbestückten Leiterplatten geeignet, bei welchen eine sehr große Anzahl von Leiterplattentestpunkten geprüft werden müssen. Die erfindungsgemäße Prüfsonde kann jedoch auch zum Testen von bestückten Leiterplatten eingesetzt werden.

Nachfolgend wird die Erfindung beispielhaft näher anhand der beigefügten Zeichnungen erläutert. Es zeigen:
- Fig. 1: einen vertikalen Schnitt durch eine erfindungsgemäße Prüfsonde und eines Teils des Schlittens des Fingertesters, an dem die Prüfsonde befestigt ist,

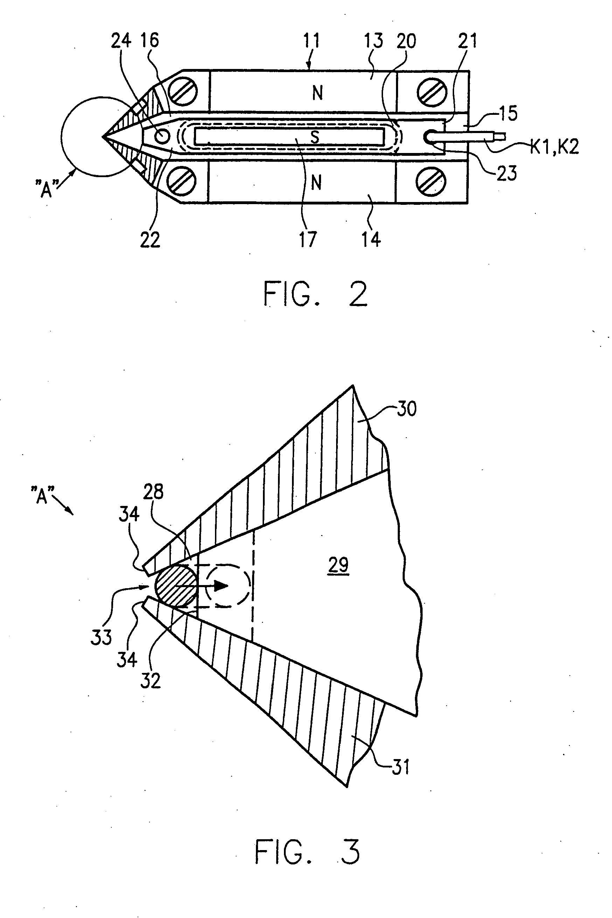

- Fig. 2: einen Querschnitt durch die in Fig. 1 gezeigte Prüfsonde entlang der Linie A-A und mit Blickrichtung entlang der Pfeile,
- Fig. 3: eine vergrößerte Ansicht eines in Fig. 2 gezeigten Führungskanals für einen Draht, und
- Fig. 4a - 4c: schematisch eine alternative Ausführungsform zum Betätigen mehrerer Prüfsonden mittels eines einzigen Aktuators.

Die erfindungsgemäße Prüfsonde 1 ist für einen Fingertester vorgesehen, der einen Schlitten 2 aufweist. Der Schlitten 2 ist in an sich bekannter Weise parallel zu einem Prüffeld (in X- und Y-Richtung) verfahrbar und weist eine Einrichtung zum vertikalen Verschieben (in Richtung des Doppelpfeils 3) auf.

Der Schlitten 2 ist mit einer Aufnahme 4 zum Befestigen der Prüfsonde 1 versehen. An der Aufnahme 4 des Schlittens 2 ist die Prüfsonde mittels einer Halterung 5 lösbar befestigt, wobei im dargestellten Ausführungsbeispiel die Prüfsonde mittels einer Schraubverbindung am Schlitten 2 befestigt ist.

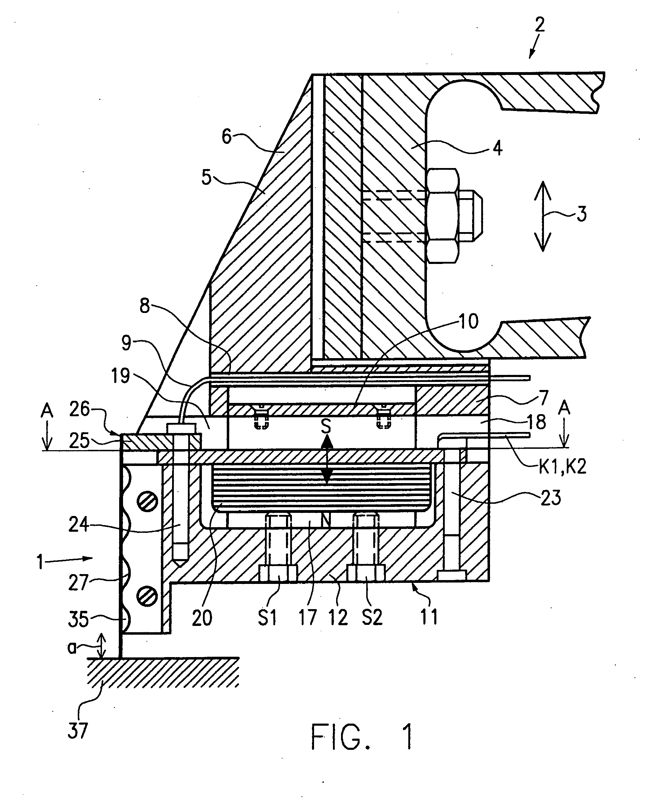

Bei dem in Fig. 1 gezeigten Ausführungsbeispiel erstreckt sich die Prüfsonde 1 vom Schlitten 2 nach unten. Diese Anordnung wird zum Kontaktieren einer elektrischen Leiterplatte von oben verwendet. Gleichermaßen ist es möglich, eine Leiterplatte von unten zu kontaktieren, wobei dann eine umgekehrte Anordnung von Schlitten 2 und Prüfsonde 1 verwendet wird. Es gibt auch Fingertester, die eine Leiterplatte an beiden Seiten testen und sowohl ober- als auch unterhalb der Leiterplatte Prüfsonden aufweisen. Bei der folgenden Beschreibung werden die Begriffe "oben" und "unten" entsprechend der in Fig. 1 gezeigten Anordnung verwendet.

Die Halterung 5 weist eine vertikale, in der Seitenansicht etwa L-förmige Wandung 6 auf, die einen sich unter die Aufnahme 4 erstreckenden Schenkel 7 besitzt. In diesem Schenkel 7 ist eine horizontale, dünne Durchgangsbohrung 8 eingebracht, durch die ein Sondenkabel 9 geführt ist. Am unteren Rand der vertikalen Wandung 6 ist eine horizontale Halteplatte 10 vorgesehen. Die Halteplatte 10 besteht vorzugsweise aus einem weichmagnetischen Material, wobei es aus Fertigungsgründen zweckmäßig sein kann, die gesamte Halterung 5 einteilig aus diesem Material zu fertigen.

An die horizontale Halteplatte 10 ist von unten ein Sondengehäuse 11 angesetzt. Das Sondengehäuse 11 weist eine Bodenwandung 12, zwei Seitenwandungen 13, 14 und zwei Stirnwandungen 15, 16 auf. Die Seitenwandungen 13, 14 sind höher als die Stirnwandungen 15, 16, so daß zwischen den Oberkanten der Stirnwandungen 15, 16 und der Halteplatte 10 jeweils ein Durchgangsspalt 18, 19 ausgebildet ist.

Parallel zu den Seitenwandungen 13, 14 ist ein plattenförmiger Eisenkern 17 vorgesehen, der wie die Bodenwandung 12 und die Halteplatte 10 aus einem weichmagnetischen Material besteht. Der Eisenkern 17 ist an der Bodenwandung 12 mittels zweier Schrauben S1, S2 befestigt.

Die Oberkante des Eisenkerns 17 fluchtet vorzugsweise mit den Oberkanten der Seitenwandungen 13, 14, so daß der Eisenkern beim Befestigen des Gehäuses 11 an der Halteplatte 10 gegen diese gedrückt und mit dieser in Berührung steht.

Die Seitenwandungen 13, 14 sind als Permanentmagnete ausgebildet, wobei sie z.B. mit ihrem Nordpol N nach oben weisend angeordnet sind. Die beiden Magnete 13, 14 sind durch die Bodenwandung 12 und die Halteplatte 10 magnetisch mit dem Kern 17 verbunden. Der Kern 17 wird hierdurch permanent vormagnetisiert, wobei er eine zu den Magneten 13, 14 entgegengesetzte Polanordnung aufweist. Bei dem in Fig. 1 gezeigten Ausführungsbeispiel weist der Kern im Bereich seiner Oberkante einen Südpol S und im Bereich seiner Unterkante einen Nordpol N auf.

Der Eisenkern 17 ist in dem durch die Wandungen 12 bis 16 begrenzten Hohlraum etwa zentriert angeordnet, so daß zwischen dem Eisenkern 17 und den beiden Stirnwandungen 15, 16 und den beiden Seitenwandungen 13, 14 jeweils ein Zwischenraum ausgebildet ist.

In dem Zwischenraum zwischen dem Eisenkern 17 und den ihn umgebenden Wandungen 13 bis 16 ist ein Spulenelement 20 eingesetzt. Das Spulenelement 20 sitzt frei beweglich auf dem Eisenkern 17, d.h., es besteht keinerlei mechanische Verbindung zwischen dem Eisenkern 17 und dem Spulenelement 20. Das Spulenelement 20 besteht aus einem rohrförmigen Trägerkörper, um den die Spule gewickelt ist. Der rohrförmige Trägerkörper weist einen flachen Querschnitt auf, so daß er den Eisenkern mit ein wenig Spiel umfaßt. Der Trägerkörper ist im Bereich der Stirnseiten an seinen Oberkanten mit in den jeweiligen Durchgangsspalt 18, 19 vorstehenden Zungen 21, 22 ausgebildet. Der Trägerkörper ist aus einem dünnwandigen Aluminiumblech gefertigt, so daß er leicht ist und ein durch die Spule erzeugtes Magnetfeld kaum beeinflußt.

An den beiden Zungen ist jeweils ein Loch eingebracht, an denen je ein nach unten weisender Führungsstift 23, 24 befestigt ist. Die Führungsstifte 23, 24 sind in vertikalen, in den Stirnwandungen 15, 16 des Gehäuses 11 ausgebildeten Führungslöcher eingesetzt, so daß das Spulenelement 20 vertikal verschieblich geführt ist.

An der Zunge 21 sind zwei elektrische Kabel K1, K2 angeordnet, welche die Spule mit einer von einer Steuereinrichtung angesteuerten Stromversorgung verbinden. Die Kabel K1, K2 werden durch den Spalt 18 von dem Spulenelement 20 nach außerhalb des Gehäuses geführt.

Die Oberkanten der Stirnwandungen 15, 16 bilden einen Anschlag für die Zungen 21, 22 des Spulenelementes, wobei bei Betätigung der Prüfsonde (Fig. 1), d.h. Stromschaltung des Spulenelementes mit einem Strom bestimmter Polarität, die Zungen an den Anschlägen anliegen. Diese in Fig. 1 gezeigte Stellung wird als Kontakt-Stellung bezeichnet, bei der ein Sondenelement 27 in Kontakt mit einer Kontaktstelle einer zu prüfenden Leiterplatte 37 steht.

Durch Stromschaltung des Spulenelementes 20 mit Strom einer entgegengesetzten Polarität zu derjenigen bei der Kontakt-Stellung wird das Spulenelement 20 nach oben gegen die Halteplatte 10 verschoben und nimmt eine Null-Stellung ein, bei der das Sondenelement 27 nicht in Kontakt mit einer der Kontaktstellen der zu prüfenden Leiterplatte steht.

Die Höhe der Durchgangsspalte 18, 19 begrenzt somit den maximalen Hub des Spulenelementes 20.

An der Zunge 21 des Trägerkörpers werden die elektrischen Leitungen der Spule durch den Durchgangsspalt 18 aus dem Gehäuse 11 herausgeführt. Die gegenüberliegende Zunge 22 ist verjüngt ausgebildet und an der Oberseite mit einem Kontaktplättchen 25 versehen. Durch das Kontaktplättchen 25 erstreckt sich der Führungsstift 24 hindurch, wobei der Führungsstift 24, das Kontaktplättchen 25 und die Zunge 22 miteinander verlötet sind. An dieser Lötstelle ist auch das Sondenkabel 9, das in einem Bogen von der Durchgangsbohrung 8 zur Lötstelle geführt ist, mechanisch und elektrisch mit dem Kontaktplättchen 25 bzw. dem Führungsstift 24 verbunden.

Das Kontaktplättchen 25 steht über die Zunge 22 nach außen vor, d.h., daß es vom Gehäuse weggerichtet ist. An der vom Gehäuse 11 entfernten Kante weist das Kontaktplättchen 25 eine Klemmeinrichtung 26 auf, an welcher ein Draht 27 austauschbar festgeklemmt werden kann. Der Draht 27 ist mit einem seiner Enden an dem Kontaktplättchen 25 festgeklemmt und erstreckt sich von dem Kontaktplättchen 25 nach unten durch einen Führungskanal 28 hindurch.

Der Führungskanal 28 wird von einem Kunststoffkörper 29 und zwei Keramikplättchen 30, 31 begrenzt.

Der Kunststoffkörper 29 weist einen etwa dreiecksförmigen Querschnitt auf, wobei er mit einer Flachseite an der Stirnwandung 16 des Gehäuses 11 befestigt ist und die der von der Stirnwandung 16 entfernt angeordnete Kante des Kunststoffkörpers 29 zu einer schmalen Führungsfläche 32 abgeflacht ist.

Die Keramikplättchen 30, 31 sind an den beiden, an der Führungsfläche 32 angrenzenden Seitenflächen des Kunststoffkörpers 29, z.B. mittels einer Schraubverbindung, befestigt und stehen über die Führungsfläche 32 vor, so daß sie spitz aufeinander zu laufen, wobei sie mit ihren Endkanten 34 einen Spalt 33 begrenzen, der schmäler als die Dicke des Drahtes 27 ist. Die Keramikplättchen sind in Richtung zu ihren freien Endkanten 34 verjüngt.

Die Führungsfläche 32 ist in der Seitenansicht wellenförmig ausgebildet, so daß der Führungskanal 28 in regelmäßigem Abstand angeordnete Ausnehmungen 35 aufweist, deren Funktion unten näher erläutert wird.

Der Kunststoffkörper 29 und die Keramikplättchen 30, 31 bilden einen Sondenkopf 36, der mit der Oberkante der Stirnwandung 16 des Gehäuses 11 fluchtet und nach unten über die Außenfläche der Bodenwandung 12 des Gehäuses ein Stück vorsteht. Die harten Keramikplättchen 30, 31 bilden einen sicheren Schutz für den Sondenkopf, falls dieser mit einer an der Leiterplatte überstehenden Lötstelle oder dergleichen in Berührung kommt. Zudem sind die Keramikplättchen 30, 31 elektrisch isolierend, so daß sie einen elektrischen Fehlkontakt im Bereich des Sondenkopfes verhindern.

Nachfolgend wird die Funktionsweise der erfindungsgemäßen Prüfsonde für einen Fingertester erläutert.

In einer Ausgangsstellung wird die Spule mit einem bestimmten Haltestrom angesteuert, wodurch das Spulenelement 20 um eine vorbestimmte Höhe h angehoben wird, so daß der Draht 27 in den Führungskanal 28 eingezogen wird. Das gesamte vertikale Bewegungsspiel des Spulenelementes 20 beträgt z.B. 1 mm.

Zur Betätigung der Prüfsonde wird das Spulenelement mit einem zum Haltestrom entgegengesetzt polarisierten Strom beaufschlagt, so daß durch das Magnetfeld des Kerns 17 eine auf das Spulenelement 20 nach unten gerichtete Kraft ausgeübt wird und das Spulenelement schlagartig nach unten bewegt wird, bis die Zungen 21, 22 an den Oberkanten der Stirnwandungen 15, 16 anschlagen.

Die zu bewegende Masse (Spulenelement, Kontaktplättchen, Führungsstifte und Draht) ist gering und zudem sind beim Übergang von der Null-Stellung in die Kontakt-Stellung wegen der freien Beweglichkeit des Spulenkörpers 20 keine mechanischen Kräfte zu überwinden, wie z.B. Federkräfte oder dgl., weshalb innerhalb von 5 ms und falls die gesamte zu bewegende Masse kleiner als 3 g ist, innerhalb von 2 ms ein Betätigungshub von 0,5 mm ausgeführt werden kann.

Nach dem Einlegen einer zu prüfenden Leiterplatte 37 in den Fingertester wird die Prüfsonde 1 durch Verschieben des Schlittens 2 vertikal bzgl. der Leiterplatte ausgerichtet. Hierbei wird ein Abstand a zwischen dem Sondenkopf 36 und der Leiterplatte 37 von z.B. kleiner oder gleich 0,5 mm eingestellt.

Die Prüfsonde 1 wird dann parallel zu der Oberfläche der zu prüfenden Leiterplatte verfahren, wobei bei Erreichen einer Kontaktstelle die Prüfsonde betätigt wird und das Sondenelement, der Draht 27, zur Herstellung eines elektrischen Kontaktes gegen die Kontaktstelle vertikal verschoben wird.

Für eine horizontale Bewegung von einer Kontaktstelle zu einer anderen Kontaktstelle werden üblicherweise etwa 50 ms benötigt. Für die vertikale Bewegung werden bei der erfindungsgemäßen Prüfsonde weniger als 5 ms benötigt, so daß die Vertikalbewegung nur einen geringen Zeitanteil von weniger als 10% an der Gesamtbewegung verursacht. Bei herkömmlichen Fingertestern benötigte man für eine Vertikalbewegung etwa 120 ms.

Beim Betätigen der Prüfsonde wird der Draht 17 im Führungskanal 28 verschoben, bis er auf der Oberfläche der zu prüfenden Leiterplatte auftrifft. Das Spulenelement 20 setzt seine Bewegung zur Leiterplatte gerichtete Bewegung fort, bis es mit seinen Zungen an den Oberkanten der Stirnwandungen 15, 16 des Gehäuses anschlägt. Der Draht 27 wird hierdurch weiter in den Führungskanal 28 eingedrückt, wobei er sich zunächst in eine erste Ausnehmung 35 ausbiegt. Zum Ausbiegen des Drahtes ist eine bestimmte Kraft notwendig, die etwa proportional zum Betätigungsweg während des Ausbiegens ist. Nach dem Ausbiegen in eine erste Ausnehmung 35 kann sich der Draht 27 noch in eine zweite, eventuell dritte Ausnehmung ausbiegen. Die hierbei vom Spulenelement aufzubringenden Kräfte sind etwa gleich und werden nur geringfügig durch die zunehmenden Reibungskräfte zwischen dem Führungskanal 28 und dem Draht 27 erhöht.

Da an der Oberfläche der zu prüfenden Leiterplatte die entsprechende Gegenkraft anliegt, ist diese auf die zum Ausbiegen des Drahtes in eine der Ausnehmungen begrenzt. Bei dem in Fig. 1 gezeigten Ausführungsbeispiel wird ein Draht aus Federstahl oder einer Kupfer-Beryllium-Legierung, wie z.B. CuBe2, mit einem Durchmesser von 40 µm verwendet. Die maximal vom Draht 27 auf eine zu prüfende Leiterplatte ausgeübte Kraft entspricht etwa der Masse von ca. 12 g bis 15 g (0,12 N bis 0,15 N). Der Betrag dieser Kraft kann durch Verändern der Form der Ausnehmungen 35 eingestellt werden, wobei bei einer längeren Vertikalerstreckung der Ausnehmungen 35 die Kraft zum Ausbiegen des Drahtes 27 geringer ist und daher eine kleinere Kraftbegrenzung erzielt wird.

Durch diese Begrenzung der vom Draht 27 auf eine Leiterplatte 37 ausgeübten Kraft können sicher Schäden an den Kontaktstellen der zu prüfenden Leiterplatten aufgrund zu hoher Kontaktkräfte vermieden werden. Bei herkömmlichen Fingertestern wurde die Zustellgeschwindigkeit, mit welcher die Testfinger auf die Kontaktstellen zu bewegt wurden, begrenzt. Dies verursacht lange Zustellzeiten, die z.B. ca. 120 ms betragen.

Die erfindungsgemäße Prüfsonde ist zudem sehr kompakt ausgebildet, d.h., daß sie eine Länge von ca. 2,5 cm und eine Tiefe von 0,8 cm besitzt. Diese kompakte Ausbildung der Prüfsonde erlaubt, daß eine Vielzahl von Prüfsonden in einer Matrix mit einem Längsabstand von z.B. 3 cm und einem Querabstand von z.B. 1 cm angeordnet werden können, wobei jede Prüfsonde individuell aktiviert werden kann. Eine solche Matrix, die etwa die Größe eines Prüffeldes aufweist muß zum Kontaktieren einer beliebigen Kontaktstelle auf der Leiterplatte nicht weiter als 3 cm in Längsrichtung und nicht weiter als 1 cm in Querrichtung bewegt werden. Hierdurch wird die für die Horizontalbewegung notwendige Zeit drastisch reduziert und eine weitere Verkürzung der notwendigen Prüfzeit erzielt.

Bei einer solchen Matrixanordnung ist vorteilhaft, daß der Draht der Prüfsonde bei Belastung ausbiegt, wodurch Toleranzen im Abstand zwischen der zu prüfenden Leiterplatte und den einzelnen Prüfsonden ausgeglichen werden. Hierdurch müssen die einzelnen Prüfsonden nicht separat bzgl. der zu prüfenden Leiterplatte justiert werden.

Eine solche Matrixanordnung kann auch in mehrere, gegenseitig verschiebbare Teile aufgeteilt sein, so daß auch Kontaktpunkte auf der zu prüfenden Leiterplatte, die nicht im Raster der Teilmatrizen angeordnet sind, kontaktiert werden können.

Die Teilmatrizen können z.B. in zwei nebeneinanderliegende, rechteckförmige Teilmatrizen aufgeteilt sein, wobei beide Teilmatrizen oder nur eine Talmatrix und die zu prüfende Leiterplatte verschieblich angeordnet sind. Bei einer vorteilhaften Ausführungsform sind die Teilmatrizen ähnlich einem Schachbrettmuster ineinander verschachtelt, wobei die Prüfsonden der einen Matriz an den weißen Feldern und die Prüfsonden der anderen Matrix an den schwarzen Feldern des Schachbrettmusters angeordnet sind. Zwischen den benachbarten Prüfsonden sind jeweils freie Zwischenbereiche ausgebildet, welche eine gegenseitige Verschiebung der beiden Matrizen erlaubt.

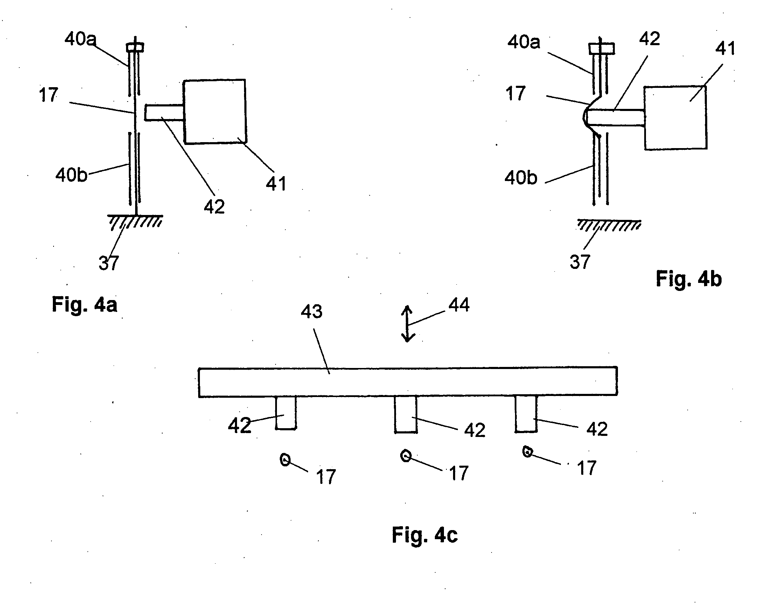

Bei einer solchen Matrixanordnung können mehrere Sondenelemente von lediglich einem Aktuator betätigt werden. Eine alternative Ausführungsform eines Aktuators, die für eine solche Mehrfachbetätigung besonders geeignet ist, ist in den Fig. 4a bis 4c gezeigt.

Bei dieser Ausführungsform ist der Draht 17 in einem oberen und einem unteren Führungsrohrabschnitt 40a, 40b geführt. Die Führungsrohrabschnitte 40a, 40b sind fluchtend und mit Abstand zueinander angeordnet, wobei der Draht 17 sich über den Zwischenbereich hinweg erstreckt. Der Draht ist am oberen Ende des oberen Führungsrohrabschnittes 40a fixiert.

Ein elektromagnetischer Aktuator 41 ist mit seinem Betätigungskolben 42 benachbart zum Draht 17 angeordnet, so daß der Betätigungskolben 42 in den Zwischenbereich zwischen den Führungsrohrabschnitten 40a, 40b eingefahren werden kann und den Draht 17 ausbiegt (Fig. 4b). Durch diese Ausbiegung des Drahtes 17 wird dessen untere Spitze in den unteren Führungsrohrabschnitt 40b eingezogen und somit von einer zu prüfenden Leiterplatte 37 abgehoben. Durch Herausziehen des Betätigungskolbens 42 aus dem Zwischenbereich zwischen den Führungsabschnitten 40a, 40b wird der Draht 17 wieder in seinen gestreckten Zustand übergeführt (Fig. 4a), wodurch die zu prüfende Leiterplatte 37 vom Draht 17 kontaktiert wird.

Um mehrere Prüfsonden bzw. mehrere Drähte 17 gleichzeitig zu betätigen, sind mehrere Betätigungskolben 42 an einer Stange 43 befestigt, die von einem einzigen Aktuator (nicht dargestellt) in Doppelpfeilrichtung 44 betätigt wird, um die benachbart zu den Betätigungskolben 42 angeordneten Drähte 17 auszubiegen bzw. wieder zu strecken. Mit einem solchen Aktuator können ganze Reihen einer Matrixänordnung gleichzeitig betätigt werden, wodurch eine wesentliche Zeitersparnis und Vereinfachung des Mechanismusses erzielt wird.

Grundsätzlich ist es jedoch auch möglich, diese Art von Aktuator zur Betätigung lediglich eines einzigen Drahtes vorzusehen.

Die Erfindung ist oben anhand eines Ausführungsbeispiels beschrieben; die Erfindung ist jedoch nicht auf die konkrete Ausführungsform beschränkt. Im Rahmen der Erfindung ist es z.B. auch möglich, daß die Klemmeinrichtung 26 durch ein Steckelement mit entsprechendem Gegensteckelement ersetzt wird. Ferner können die magnetischen Teile 12, 13, 14, 17 des Gehäuses 11 in ein weiteres, dünnwandiges Schutzgehäuse eingebaut sein.

## Patentansprüche

1. Fingertester zum Prüfen von Leiterplatten mit einer Prüfsonde, aufweisend zumindest zwei horizontal über einem Prüffeld verfahrbare Schlitten (2), an denen jeweils eine Prüfsonde befestigbar ist und eine Einrichtung zum Verstellen der vertikalen Position der Prüfsonde (1),
**dadurch gekennzeichnet,**
**daß** die Prüfsonde (1) einen Aktuator aufweist, der ein Sondenelement (27) unabhängig von der Einrichtung zum Verstellen der vertikalen Position der Prüfsonde (1) in Vertikalrichtung zum Kontaktieren einer Kontaktstelle einer Leiterplatte betätigen kann.

2. Fingertester nach Anspruch 1, wobei der zum Kontaktieren einer Kontaktstelle ausgeführte Arbeitshub des Aktuators kleiner als 2 mm und vorzugsweise kleiner als 1 mm ist.

3. Fingertester nach Anspruch 1 oder 2, wobei eine Vielzahl von Prüfsonden in einer Matrixanordnung vorgesehen sind, wobei die gesamte Matrixanordnung horizontal über einer zu prüfenden Leiterplatte bewegt wird, und jede Prüfsonde von einem Aktuator betätigbar ist, um jeweils ein Sondenelement in Vertikalrichtung zu betätigen, wobei die Prüfsonden unabhängig voneinander betätigbar und gemäß einem der Ansprüche 1 bis 14 ausgebildet sind.

4. Fingertester nach einem der Ansprüche 1 bis 3, wobei eine Vielzahl von Prüfsonden in einer Matrixanordnung vorgesehen sind, wobei die gesamte Matrixanordnung horizontal über einer zu prüfenden Leiterplatte bewegt wird, und jede Prüfsonde von einem Aktuator betätigbar ist, um jeweils ein Sondenelement in Vertikalrichtung zu betätigen, und daß das Sondenelement ein elastischer Draht ist, der in einem Führungskanal geführt ist, der mit zumindest einer Ausnehmung versehen ist, in welche der Draht bei Belastung ausbiegen kann.

5. Fingertester nach Anspruch 3 oder 4, wobei die Matrixanordnung in mehrere Teilmatrizen unterteilt ist, wobei die Teilmatrizen zueinander verschieblich ausgebildet sind.

6. Fingertester nach einem der Ansprüche 1 bis 5, wobei mehrere Sondenelemente von einem einzigen Aktuator betätigbar sind.

7. Prüfsonde (1) für einen Fingertester nach einem der vorhergehenden Ansprüche, aufweisend:
ein Sondenelement (27) zum elektrischen Kontaktieren einer Kontaktstelle einer zu prüfenden Leiterplatte (37),
einen Aktuator mit einem permanent vormagnetisierten Kern (17) und einem Spulenelement, die relativ zueinander beweglich sind, wobei eines der beiden Teile fixiert und das andere Teil beweglich ist,
wobei das bewegliche Teil mechanisch mit einem Sondenelement (27) verbunden ist, so dass bei Stromschaltung das bewegliche Teil zusammen mit dem Sondenelement (27) bewegt wird, und wobei das bewegliche Teil frei beweglich am fixierten Teil angeordnet ist,
und wobei das Sondenelement ein elastischer Draht (27) ist, der in einem Führungskanal (28) geführt ist, der mit mehreren Ausnehmungen (35) versehen ist, in welche der Draht bei Belastung ausbiegen kann.

8. Verfahren zum Prüfen von Leiterplatten mit einem Fingertester,
wobei der Fingertester eine Prüfsonde mit einem Aktuator ist, der ein Sondenelement (27) in Vertikalrichtung zum Kontaktieren einer Kontaktstelle einer Leiterplatte betätigen kann, zumindest zwei horizontal über einem Prüffeld verfahrbare Schlitten (2), an denen jeweils eine Prüfsonde befestigt ist, und eine Einrichtung zum Verstellen der vertikalen Position der Prüfsonde (1) aufweist, umfassend folgende Schritte:
- Einlegen einer zu prüfenden Leiterplatte (37) in das Prüffeld,
- Einstellen eines vorbestimmten Abstandes a zwischen den Prüfsonden und der Leiterplatte (37) mittels der Einrichtung zum Verstellen der vertikalen Position der Prüfsonde (1),
- Verfahren der Prüfsonden parallel zur Oberfläche der zu prüfenden Leiterplatte, wobei bei Erreichen einer Kontaktstelle der Aktuator das Sondenelement (27) in Vertikalrichtung zum Kontaktieren der jeweiligen Kontaktstelle betätigt.

9. Verfahren nach Anspruch 8, wobei der vorbestimmte Abstand a kleiner oder gleich 0,5 mm ist.

10. Verfahren nach Anspruch 8 oder 9, wobei das Verfahren mit einem Fingertester gemäß einem der Ansprüche 1 bis 6 ausgeführt wird.

11. Verfahren nach einem der Ansprüche 8 bis 10, wobei eine Prüfsonde (1) nach Anspruch 7 verwendet wird.
